# EUROPEAN PATENT APPLICATION

(11) **EP 4 187 749 A1**
(43) Date of publication of application: **31.05.2023**
(21) Application number: 21210095.2
(22) Date of filing: 24.11.2021
(51) Int. Cl.: H02J 7/00, H02J 7/02, B60L 53/302

(54) **A MOBILE CHARGING STATION**

(71) Applicant: Sandvik Mining and Construction Oy, 33330 Tampere (FI)
(72) Inventor: ERIKSSON, Harri, 33311 Tampere (FI); VIERIKKO, Jaakko, 33311 Tampere (FI)
(74) Representative: Sandvik

(57) **Abstract**

A mobile charging station (100) for charging a vehicle in an underground mine is provided. The mobile charging station (100) comprises an electric input (102) configured to receive an input voltage from an electrical network of a mine, at least one output (108) configured to charge a battery of the vehicle connected to the output, a charging circuitry (106) configured to provide electric power to the at least one output (108), and a voltage transformer (104) arranged between the electric input (102) and the charging circuitry (106), the voltage transformer (104) being configured to transform the input voltage received via the electric input (102) to a configured output voltage for the charging circuitry.

## Description

### TECHNICAL FIELD

This disclosure relates to charging equipment applied in a mining environment. Particularly, this disclosure relates to a mobile charging station.

### BACKGROUND

Charging equipment is widely used in various applications. The charging equipment comes in all sizes and they have different requirements with regard charging power. A need for a high charging power may occur in working machines used, for example, in a mining environment. The working machines can be equipped with large batteries in order to enable them to be used for longer periods without unproductive pauses during a working period. Some of the working machines may be heavy duty machines that also consume a lot of operating power. Thus, they may need to be charged during the working period, and the charging speed should then be as fast as possible so that critical machines are not out of work long.

One special example of a field involving such machines is the mining industry. Mining is power consuming and, at the same time, electricity grids in mines may often be of limited quality. A mining environment may cause both technical and economical limitations that need to be considered when an electricity grid is constructed to a mine. Furthermore, the load in an electricity grid in a mine typically varies because different tools and machines are charged and used in irregular intervals.

A further characteristic with mines is that they may be in a remote location. The distribution network line or public network may be insufficient for providing the needed electricity. In such cases additional electricity is provided using local power sources, such as diesel generators. Using generators is expensive and particularly situations where additional power is needed also additional costs are caused because of starting additional generator capacity. Thus, it is desired to keep the required peak power as low as possible while still providing enough electricity for the operation of the mine.

When charging is used in the mining industry for charging a battery, for example, a battery of an underground mining vehicle in a mine, a separate transformer may be arranged to transform an input voltage to a desired output voltage for the charger. This may lead to a situation in which each charger needs a separate isolation transformer. Further, dependent on a country, different voltage levels may be in use. This may also mean that the transformer needs to be selected so that it can be used in the country in question.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter. The scope of protection sought for various embodiments of the present disclosure is set out by the independent claims.

Example embodiments of the present disclosure enable an integrated mobile charging station comprising both a charging circuitry and a transformer in an underground mining environment. This and other benefits may be achieved by the features of the independent claims. Further advantageous implementation forms are provided in the dependent claims, the description, and the drawings.

According to an aspect, there is provided a mobile charging station for charging a vehicle in an underground mine. The mobile charging station may comprise an electric input configured to receive an input voltage from an electrical network of a mine and at least one output configured to charge a battery of the vehicle connected to the output. The mobile charging station may comprise a charging circuitry configured to provide electric power to the at least one output, and a voltage transformer arranged between the electric input and the charging circuitry, the voltage transformer being configured to transform the input voltage received via the electric input to a configured output voltage for the charging circuitry. A solution may therefore be provided in which the charging station used in the underground mining environment comprises a built-in transformer without a need to arrange an external transformer. Further, as a single mobile charging station including a transformer can be used, space savings are achieved. Further, relocation of a single mobile charging station is fast and easy.

In an implementation form, the voltage transformer may comprise a multi-voltage transformer. When a multi-voltage transformer is used, the same mobile charging station may be used in different voltage environments, for example, in different countries using different voltage levels. An input voltage level applied by the mobile charging station may be configured in the field, i.e. on site.

In an implementation form, the mobile charging station further comprises a cooling unit power output configured to provide operating power for a cooling unit, and connecting means for connecting the cooling unit to the mobile charging station, the cooling unit being configured to cool at least one power electronics element of the mobile charging station. As the transformer is arranged inside the mobile charging station, the cooling unit may be configured to cool also the transformer. If the transformer was arranged as a separate entity from the charging station, a separate cooling arrangement would have to be arranged for the transformer.

In an implementation form, the cooling unit is detachably connectable to the mobile charging station. This may enable a modular design in which different functional entities may be arranged in different modules. These modules may be arranged to be stackable on top of each other or detachably connectable side by side.

In an implementation form, the charging circuitry and the voltage transformer are configured in a single module. This may enable a solution in which electrical components can be positioned efficiently. Further, the overall size of the mobile charging station can be kept small enabling the mobile charging station to fit in a mine elevator.

In an implementation form, the voltage transformer is configured to be removably replaceable. This may enable a solution in which, depending on the implementation environment (for example, the country or mining site), a suitable voltage transformer may be installed in the mobile charging station.

### BRIEF DESCRIPTION OF THE DRAWINGS

The accompanying drawings, which are included to provide a further understanding of the charging apparatus and constitute a part of this specification, illustrate examples and together with the description help to explain the principles of the charging apparatus. In the drawings:
**FIG. 1A** illustrates a block diagram of a mobile charging station for charging a vehicle in an underground mine according to an example embodiment.
**FIG. 1B** illustrates a block diagram of a mobile charging station for charging a vehicle in an underground mine according to another example embodiment.
**FIG. 2** illustrates a circuit diagram for a mobile charging station for charging a vehicle in an underground mine according to an example embodiment.

Like reference numerals are used to designate like parts in the accompanying drawings.

### DETAILED DESCRIPTION

Reference will now be made in detail to embodiments, examples of which are illustrated in the accompanying drawings. The detailed description provided below in connection with the appended drawings is intended as a description of the present examples and is not intended to represent the only forms in which the present example may be constructed or utilized.

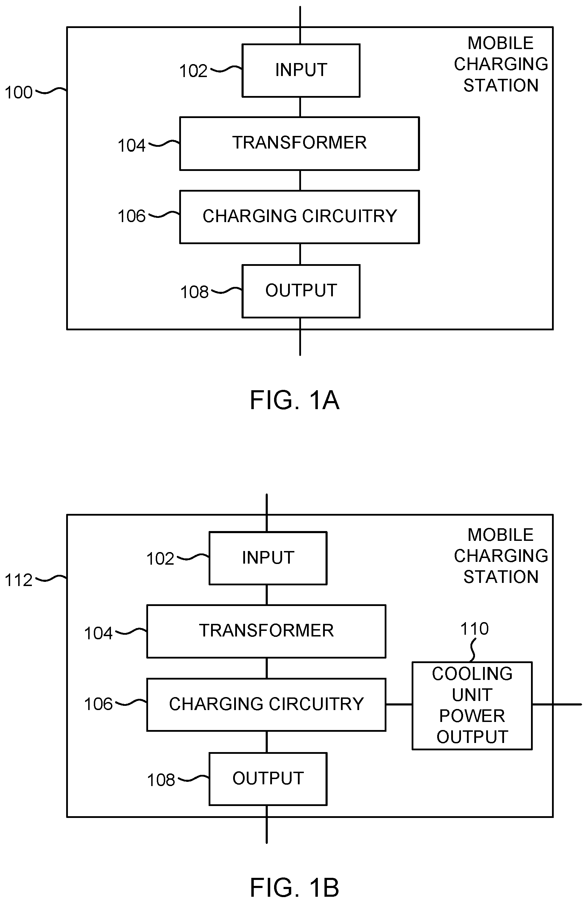

FIG. 1A is a block diagram of a mobile charging station 100 for charging a vehicle in an underground mine according to an example embodiment. The vehicle may be, for example, a mining vehicle or a transport vehicle used in the mine. The term "mobile charging station" used herein may refer to a charging station that may be transported to a mine as a single functional module by using, for example, a mine elevator. The mobile charging station 100 may be used, for example, in an underground mining environment. In another example embodiment, the mobile charging station 100 may be used also in an environment above ground. The mobile charging station 100 may comprise an electric input 102 configured to receive an input voltage from an electrical network of a mine, and at least one output 108 configured to charge a battery of the vehicle connected to the output 108. The mobile charging station 100 may comprise a charging circuitry 106 configured to provide electric power to the at least one output 108. An output voltage at the output 108 may be controllable being, for example 480-850Vdc. The mobile charging station 100 may comprise a voltage transformer 104 arranged between the electric input 102 and the charging circuitry 106. The voltage transformer 104 may be configured to transform the input voltage received via the electric input 102 to a configured output voltage for the charging circuitry 106.

A mobile charging station 100 may be useful, for example, when an underground mine expands. The mobile charging station 100 can be moved along with the expansion to a desired location in the mine.

The voltage at the electric input 102 may be different, for example, in different countries or different sites. In an example embodiment, the mobile charging station 100 may comprise a single transformer that has been specifically configured to be used in a site having a specific input voltage level. This may mean, for example, that the voltage transformer 104 may be selected to be suitable for the voltage level used in the site.

In an example embodiment, the voltage transformer 104 may comprise a multi-voltage transformer. When a multi-voltage transformer is used, the same mobile charging station comprising the transformer may be used in different voltage environments, for example, in different countries or different sites, for example, underground mines. A desired input voltage used by the mobile charging station 100 may be configured, for example, in the field, i.e. on site. This enables a solution in which the same device, i.e. the mobile charging station 100, may be used in multiple environments as the multi-voltage transformer is configurable to use different input voltage levels, for example, 480Vac, 600Vac or 1000Vac. In another example embodiment, the voltage transformer 104 may be configured to be removably replaceable. This may enable a solution in which, depending on the implementation environment (for example, the country or mining site), a suitable voltage transformer may be installed in the mobile charging station 100.

A single mobile charging station, i.e. a mobile charging station comprising a transformer, can be used without a need to arrange an external transformer. This may bring in practice also other benefits. For example, installation procedures become simpler as a separately arranged transformer is not needed any more. This means also faster installation. Further, as a single mobile charging station including a transformer can be used, space savings are achieved. Further, relocation of the mobile charging station is fast and easy. Further, a galvanic decoupling provided by the voltage transformer 104 reduces interferences towards a supply network provided by an internal frequency converter of the mobile charging station 100.

In an underground mine, space available in the mine may be limited. This may apply also when equipment is transported into the mine by using, for example, an elevator. Elevators in underground mines may have limited spaced available for transportation. When integrating the transformer into the charging station, this may provide a reduction in size compared to a situation in which the transformer is a separate element from the charging station, and the mobile charging station 100 can be transported into the mine using the mine elevator in a single elevator travel.

FIG. 1B is a block diagram of a mobile charging station 112 for charging a vehicle in an underground mine according to another example embodiment. The mobile charging station 112 is identical with the mobile charging station 100 with the exception that the mobile charging station 112 comprises a cooling unit power output 110 configured to provide operating power for a cooling unit. The mobile charging station 112 may also comprise connecting means for connecting the cooling unit to the mobile charging station 112, the cooling unit being configured to cool at least one power electronics element of the mobile charging station 112, for example, the voltage transformer 104, an inverter and a filter. The cooling unit may be detachably connectable to the mobile charging station with the connecting means. This may enable a modular design in which different functional entities may be arranged in different modules. These modules may be arranged to be stackable on top of each other or detachably connectable side by side. For example, a module or modules may comprises attaching means with which the modules may be connected to each other. The attaching means may comprise, for example, one or more grooves, one or more latches or other locking means etc. In an example embodiment, the modules, for example, the mobile charging station and the cooling unit, may be locked to each other by putting a locking bar through holes arranged in the bottom of the base of the module. When mounted in a pile, the bottom unit hoisting brackets are inside the base of the top unit and the locking bar will go through the holes of the brackets. Locking pins may be installed to the other end of the locking bars.

The cooling unit may be configured to cool, for example, the transformer 104, the charging circuitry 106 and/or any other component or module of the mobile charging station 112 that heats during the operation of the mobile charging station 112. The cooling unit may be configured to provide water cooling for the mobile charging station 112. When cooling is used, the mobile charging station 112 may be able to provide an output power of 300-320kW. Further, the voltage transformer 104 may limit a short-circuit current for all components connected to secondary windings of the transformer. Further, dimensioning of various components is easier for smaller short-circuit currents. Further, arc flash energy during a short circuit is smaller, thus providing also a safer solution.

In an example embodiment, the charging station comprising both the voltage transformer and the charging circuitry may be configured to be mobile and modular, thus enabling, for example, connecting different functional entities in different modules with each other. Further, the voltage transformer may be configured as a multi-voltage transformer enabling the use of the same charging station in different voltage environments, for example, in different countries or mining sites using different voltage levels. This combination, i.e. mobile, modular, integrated and multi-voltage, may provide a solution that has synergic advantages as a single charging station is able to provide multiple functionalities.

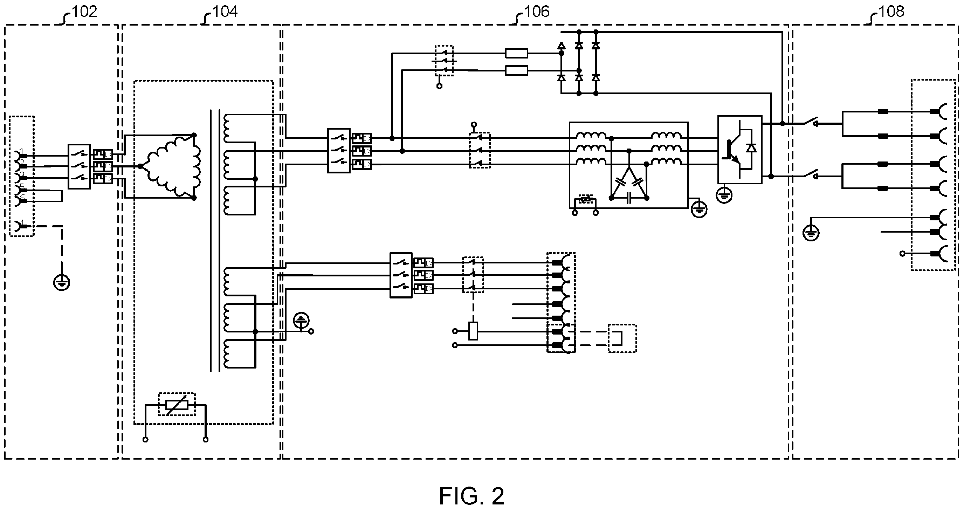

FIG. 2 illustrates a circuit diagram for a mobile charging station 100, 112 according to an example embodiment.

It is obvious to a person skilled in the art that with the advancement of technology, the basic idea of the mobile charging station may be implemented in various ways. The mobile charging station and its embodiments are thus not limited to the examples described above; instead they may vary within the scope of the claims.

## Claims

1. A mobile charging station (100, 112) for charging a vehicle in an underground mine, the mobile charging station (100, 112) comprising:
an electric input (102) configured to receive an input voltage from an electrical network of a mine;
at least one output (108) configured to charge a battery of the vehicle connected to the output (108);
a charging circuitry (106) configured to provide electric power to the at least one output (108); and
a voltage transformer (104) arranged between the electric input (102) and the charging circuitry (106), the voltage transformer (104) being configured to transform the input voltage received via the electric input (102) to a configured output voltage for the charging circuitry (106).

2. The mobile charging station (100, 112) of claim 1, wherein the voltage transformer (104) comprises a multi-voltage transformer.

3. The mobile charging station (100, 112) of claim 1 or 2, further comprising a cooling unit power output (110) configured to provide operating power for a cooling unit; and
connecting means for connecting the cooling unit to the mobile charging station (100, 112), the cooling unit being configured to cool at least one power electronics element of the mobile charging station (100, 112) .

4. The mobile charging station (100, 112) of claim 3, wherein the cooling unit is detachably connectable to the mobile charging station (100, 112).

5. The mobile charging station (100, 112) of any of claims 1 - 4, wherein the charging circuitry (106) and the voltage transformer (104) are configured in a single module.

6. The mobile charging station (100, 112) of any of claims 1 - 5, wherein the voltage transformer (104) is configured to be removably replaceable.
